# EUROPÄISCHE PATENTANMELDUNG

(11) **EP 1 251 397 A2**
(43) Veröffentlichungstag der Anmeldung: **23.10.2002**
(21) Anmeldenummer: 02006942.3
(22) Anmeldetag: 26.03.2002
(51) Int. Cl.: G03F 1/14

(54) **Herstellung von optisch abgebildeten Strukturen mit einer Phasenschiebung von transmittierten Lichtanteilen**

(30) Priorität: 27.03.2001 DE 10115010; 10.08.2001 DE 10148209
(71) Anmelder: FRAUNHOFER-GESELLSCHAFT ZUR FÖRDERUNG DER ANGEWANDTEN FORSCHUNG E.V., 80636 München (DE)
(72) Erfinder: Erdmann, Andreas, 91056 Erlangen (DE); Vial, Alexandre, 91056 Erlangen (DE)
(74) Vertreter: Leonhard, Frank Reimund, Dipl.-Ing.

(57) **Zusammenfassung**

Die Erfindung betrifft ein Verfahren zum Herstellen oder Erzeugen von optisch abbildbaren Strukturen, insbesondere in einer Größenordnung unter 1µm, auf einem Substrat (2), wie Halbleiterchip oder Halbleiterwafer. Dabei wird eine Maske (10) verwendet, die entsprechend der Gestalt von zu bildenden kleinen Strukturen (13a,13b) lichtdurchlässig (10a,10b,10c) ist, zum Belichten der kleinen Strukturen und zum Ausbilden einer Intensitätstopologie (3a,13a,13b) auf einer lichtempfindlichen Schicht (3), die auf dem Substrat (2) - insbesondere dem Halbleiter - aufgebracht ist. Ein erstes Teilverfahren zur Definition einer Form und Verteilung der lichtdurchlässigen Bereiche (10a,10b,10c) in oder auf der Maske (10) wird räumlich und zeitlich getrennt von einem zweiten Teilverfahren zur Veränderung der Phasenlage (12a) der durch bestimmte Bereiche (10a,10c) der lichtdurchlässigen Bereiche transmittierten Lichtanteile (L10a) während der Belichtung der lichtempfindlichen Schicht (3).

## Beschreibung

Die Erfindung befaßt sich mit einem Verfahren zur Herstellung oder zum Erzeugen von kleinen Strukturen auf Substraten, Halbleiterchips oder solchen Wafern, die als "Halbleiter" bezeichnet werden sollen. Auch betroffen ist eine Vorrichtung zur Durchführung des Verfahrens.

Von einer Lichtquelle ausgehend bildet eine mit für das einfallende Licht transparenten und nicht-transparenten Bereichen belegte Maske eine Intensitätsstruktur, die über ein Projektionssystem auf eine Photolack-Schicht als lichtempfindliche Lage auf dem Substrat, wie Halbleiter, abgebildet wird und dabei Strukturen ausbildet oder zumindest zur Ausbildung vorbereitet, wenn die belichteten Bereiche (Positiv-Resist oder Negativ-Resist) entwickelt und dabei in der Tiefe strukturell ausgebildet werden. Auf eine Struktur wird dabei schon insoweit Bezug genommen, als diese Struktur durch eine Intensitätstopologie im Sinne einer in der Intensität variierenden Strahlung auf der Ebene der photoempfindlichen Schicht entsprechend der Intensität der Strahlung chemisch verändert wird.

Die optische Projektionslithographie wird seit mehr als 20 Jahren als ein Standardwerkzeug zur Erzeugung kleiner Strukturen auf Halbleitern eingesetzt. Die Maske wird dabei mit einem optischen Abbildungssystem in die lichtempfindliche Schicht, den Photolack oder - wie oben beschrieben - den Resist abgebildet. Das Auflösungsvermögen des Systems und damit die Größe der abbildbaren Strukturen hängt von mehreren Faktoren ab: Die räumliche Kohärenz, die Wellenlänge λ (lambda) der Beleuchtung und schließlich auch vom Öffnungswinkel des Projektionssystems, oft über die numerische Apertur (NA) beschrieben.

Es versteht sich, daß auch im Stand der Technik viele Ansätze existieren, das Auflösungsvermögen zu steigern, z.B. durch Reduzierung der Wellenlänge hin zu einer Röntgenlithographie. Andere Wege verändern die Art der Maske, um zusätzlich zu einer Transmission in einem lichtdurchlässigen Bereich auch die Phase des durchstrahlten Lichtes zu verändern, wobei transparente Bereiche mit unterschiedlicher Phaseninduzierung benachbart sind, aber jeweils zwischen sich einen nicht-transparenten Bereich aufweisen, vgl. die so zu nennenden Levenson-Phasen-Shift-Maske nach **Levenson, Visnawathan, Simpson,** "Improving Resolution in Photolithography with a Phase Shifting Mask", IEEE Transactions on Electron. Devices, 29 (1982), Seiten 1828 ff. oder **WO 01/06320** (Levenson). Die Wirkungsweise einer solchen alternierenden Phaseshift-Maske im Vergleich zu einer binären Maske kann anhand des Transmissionsverhaltens von benachbarten lichtdurchlässigen Abschnitten beschrieben werden. Jeweils abwechselnd besitzen benachbarte transmittierende Abschnitte eine unterschiedliche Glasdicke, wodurch die unterschiedlichen Phasenschiebungen von benachbarten transmittierten Bereichen erzeugt werden, vgl. dazu die ATN-Phasenmaske und die ALT-Phasenmaske gemäß **Widmann, Mader**, **Friedrich,** "Technologie hochintegrierter Schaltungen", Springer Verlag, zweite Auflage, S. 136, Abb. 4.2.25a bis e, sowie **JP-A 03-208 050** (Fujitu). Bei den genannten Masken ergeben sich von binären Masken abweichende Beugungsspektren, wobei erste Beugungsordnungen von binären Masken mit beispielsweise NA = 0,5 bei sin θ = 0,6 liegen. Die Modulation der Phase bei einer alternierenden Phasenshift-Maske verschiebt die ersten Beugungsordnungen zu kleineren Winkeln sin θ = 0,3. Aus Luftbildern kann entnommen werden, daß ein optisches Projektionssystem mit einem Öffnungswinkel NA = 0,5 im wesentlichen nur die 0te Beugungsordnung erfaßt und eine Struktur der Maske im Bild nicht aufgelöst wird. Im Gegensatz dazu kann die erste Beugungsordnung bei einer Phasenshift-Maske durch das Projektionssystem übertragen und im Bild aufgelöst werden, also als Strukturtopologie oder Intensitätstopologie mit steilen Flanken in der lichtempfindlichen Schicht auf dem Halbleiter abgebildet werden.

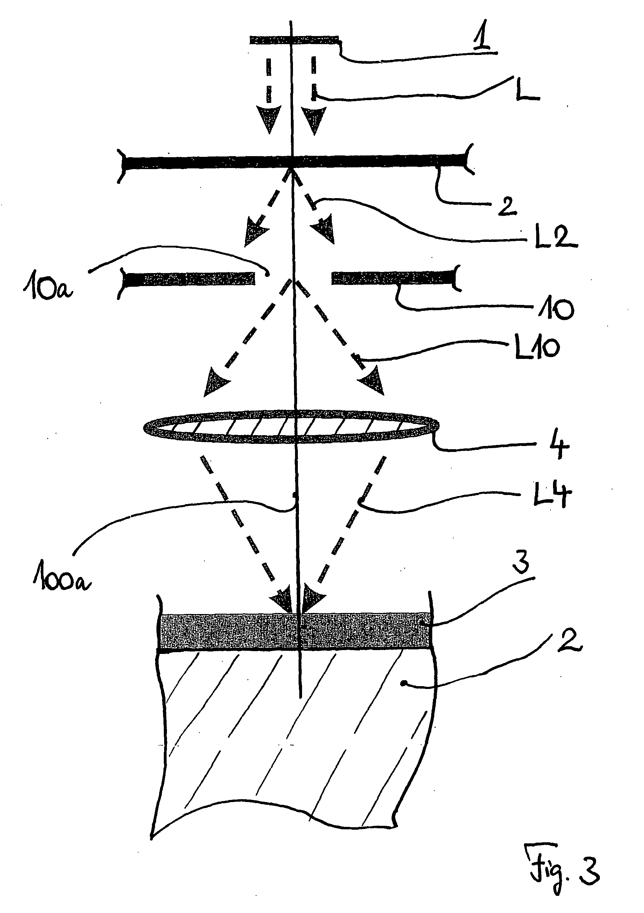

Eine bisherige Herstellung einer Phasenshift-Maske erfolgt durch Ätzen entsprechend unterschiedlich tiefer Öffnungen in das Glassubstrat, vgl. z.B. **EP-A 807 851** (Mitsubishi) in der dortigen Figur 29, 30 und 31 mit den Bezugszeichen Tn und Ta als benachbarte, unterschiedlich in der Phase wirkende durchlässige Bereiche einer Phasenshift-Maske oder aber **US 5,702,848** (Spence) mit der dortigen Figur 2a,2b bei entsprechendem Intensitätsverlauf in den Figuren 2c,2d sowie der zugehörigen Beschreibung in Spalte 1, Zeile 63 bis Spalte 2, Zeile 37. Alternative Phasenshift-Masken sind auch in **US 6,013,396** (Capodieci) beschrieben, vgl. dort die Figuren 3 sowie den Verfahrensablauf in der dortigen Figur 9 und die zugehörige Beschreibung in Spalte 2, Zeilen 18 bis 51, auf die zur Erläuterung von Phasenshift-Masken, von Standardverfahren zur Herstellung einer COG-Maske und dem bisherigen Leistungsergebnis Bezug genommen wird.

Eine theoretische Untersuchung mit Hilfe von rigorosen elektromagnetischen Feldsimulationen, vgl. dazu **Erdmann, Friedrich,** "Rigorous Diffraction Analysis for Future Mask Technology", SPIE Proceedings 4000 (2000), Seiten 684 ff., hat ergeben, daß Lichtbeugung an den Kanten der im Glas vorgesehenen Bereiche und die Resttransmission der nicht-transmittierenden (also opaken) Bereiche aus z.B. Chrom zu Imbalancing-Effekten führen, die in der obigen Schrift aus SPIE 2000, S. 684 ff. näher erläutert sind. Die zueinander in der Phase verschobenen Bereiche zeigen - kurz zusammengefaßt - unterschiedliche effektive Transmissionen, was zu asymmetrischen Bildern bzw. zu deplazierten Photolack-Profilen führt. Versuche, diese Ungenauigkeiten in den Griff zu bekommen, erweisen sich als schwierig, bezogen auf die genaue Beherrschung des Ätzprozesses und die Maßhaltigkeit sowie Defektfreiheit der Maskenstrukturen. Mit weiteren Varianten, das Chrom als nicht-transmittierenden Abschnitt über den Maskenkanten abzuschneiden, vgl. dazu **WO-A 01/06320** (Levenson), dortige Figuren 22 und 23 sowie zugehörige Beschreibung auf Seite 10 ab Zeile 9 bis 26, konnten eine Verbesserung der Symmetrie des Bildes nach dem Abbildungssystem zwischen der Lichtquelle und der Maske erreicht werden, jedoch ist die Abscheidung des nicht-transparenten Bereiches (also des Chroms) über den Glaskanten als äußerst schwierig zu bewerten.

Die Erfindung hat sich zum Ziel gesetzt und damit hier zur **technischen** Problemstellung gemacht, Verbesserungen vorzuschlagen und die Beibehaltung kleiner Maskenstrukturen bei brauchbarer Fokustiefe zu erreichen bzw. zu erhalten und dennoch die Herstellungskosten zu senken. Mit anderen Worten soll eine einfachere Herstellung der Maske erreicht werden, ohne daß sich die Erstellung der grundsätzlichen Maskengeometrie und der Einbringung der phasenschiebenden, lichttransmittierenden Bereiche gegeneinander beeinflussen und somit die Herstellung erschwert. Mit der kostengünstigeren Herstellung ist auch eine technisch einfachere Herstellung erfindungsgemäß verbunden.

Vorgeschlagen wird dazu, den Maskenprozeß, also den Prozeß zur Definition der Maskentransmission (der nicht-transmittierenden und der transmittierenden Bereiche und ihre räumlich/geometrische Anordnung) zu trennen von demjenigen Verfahrenschritt, mit dem die Phase in bestimmten der transmittierenden Bereiche gegenüber den übrigen transmittierenden Bereichen verschoben wird (Anspruch 1, Anspruch 20, Anspruch 21). Damit können Standardverfahren zur Herstellung einer binären Maske (als COG-Maske oder andere Masken mit scharfen Konturen zwischen den transmittierenden und nicht-transmittierenden Bereichen) eingesetzt werden.

Die Herstellung der binären Maske ist räumlich und zeitlich getrennt von den beim Belichten angewendeten Teilverfahren zur Veränderung der Phasenlage. Die Veränderung der Phasenlage geschieht oberhalb der Maske, also oberhalb der transmittierenden und der nicht-transmittierenden Bereiche (Anspruch 20), bevorzugt durch ein Hologramm (Anspruch 3), mit dem in denjenigen Bereichen, die eine Phasenschiebung erhalten sollen, entsprechende Phasenschiebungen auf das transmittierte Licht schon vor Erreichen der Maske eingebracht wird. "Vor" ist hier im räumlichen Sinne zu sehen, entlang einem Strahlenweg oder einer optischen Achse (Anspruch 4). Bevorzugt durch ein Hologramm wird eine Phasenlage induziert, bezogen auf jeweils zwei benachbarte, aber beabstandet transparente Bereiche (Anspruch 6).

Im einfachen Fall enthält das Hologramm, das zwischen Lichtquelle und Maske angeordnet ist, ein Phasengitter, um ein Interferenzmuster auf die Maske zu projizieren, insbesondere in den transmittierenden Bereichen der Maske, in denen die Phasenschiebung erfolgen soll (Anspruch 11, 14 und 15). Die Beleuchtung mit in der Phase verschobenen Lichtanteilen kann auch über die bestimmten transmittierenden Bereiche, die die Phasenschiebung erhalten sollen, hinaus erfolgen, wenn insoweit eine Abdeckung angrenzend an einen nicht-transmittierenden Bereich definiert ist (Anspruch 5, bezogen auf die abwechselnde Anordnung von transparenten und nicht-transparenten Bereichen und die abwechselnde Vorsehung von phasenschiebenden und nicht-phasenschiebenden transparenten Bereichen).

Die Erfindung ist anwendbar auf Halbleiterkristalle (Anspruch 18), die bevorzugt zu Speicherbausteinen oder Logikbausteinen weiterverarbeitet werden, welche weitere Verfahrensschritte durch Entwicklung der belichteten lichtempfindlichen Schicht und weitere Prozeßschritte wie Ätzen, Dotieren und Ähnliches gebildet werden. Unter einer Entwicklung ist eine Ausbildung einer Tiefenstruktur zu verstehen (Anspruch 19).

Als Struktur wird gemäß Anspruch 1 auch eine solche Struktur verstanden, die eine Intensitätstopologie, also eine Verteilung unterschiedlicher Intensitäten entsprechend der Ausbildung der Maske auf der lichtempfindlichen Schicht erreicht (Anspruch 16). Die kleinen Strukturen sind so zu verstehen, daß es sich um kleine optisch abgebildete Strukturen handelt, insbesondere in Größenordnungen unter 1µm (micrometer) bis hin zu derzeit 200nm, was aber abhängig vom Anwendungsfall (Speicherbaustein, Logikbaustein oder andere Bausteine) sein kann. Als Substrat, dem die lichtempfindliche Schicht aufgelagert ist, ist nicht nur ein Halbleiter als Kristall oder Chip oder Wafer zu verstehen, sondern auch andere Substrate, wie Metalle, Isolatoren, die nach einem Belichten und Entwickeln einer über ihnen liegenden lichtempfindlichen Schicht als Leiterbahnen oder Isolationsbahnen ausgebildet werden sollen.

Als Licht kann für die Erfindung nicht nur sichtbares sondern auch Licht im tiefen UV-Bereich, beispielsweise 157 nm oder 193 nm Wellenlänge, Verwendung finden (Anspruch 9).

Die Realisierung der erforderlichen Phasenschiebung ist vom eigentlichen Maskenprozeß getrennt (Anspruch 1). Die Beleuchtung der (binären) Maske mit einem zum Anwendungszweck geeigneten Interferenzmuster (nach Intensität und/oder Phase) schafft die Möglichkeit, die Phasenschiebung ohne Höhenunterschiede in den transmittierenden Bereichen der Maske zu erhalten. Das Interferenzmuster wird beispielsweise durch ein Hologramm realisiert (Anspruch 2, 3), insbesondere abgebildet über ein optisches Abbildungssystem, wobei Hologramm und Abbildungssystem diesseits und jenseits der Maske im Strahlenweg (in der optischen Achse) angeordnet sind.

Das Hologramm kann sich bevorzugt auf der Rückseite der Maske (derjenigen Seite der Maske, die der Lichtquelle zugewandt ist), befinden, insbesondere nahe oder auf einer Masken-Schutzschicht, die als Pellicle bezeichnet wird (Anspruch 12). Die Beleuchtung der binären Maske (Anspruch 13) mit einem geeigneten Interferenzmuster induziert die entsprechenden Phaseneffekte für das durchgestrahlte Licht.

Die gewünschte Phasenverteilung kann durch geeignetes Design des Hologramms realisiert werden. Rigorose Beugungseffekte, welche Asymmetrien im projizierten Bild auf der lichtempfindlichen Schicht hervorrufen, können durch geeignetes Design der Hologramme so weitgehend als möglich vermieden werden.

Durch die Einführung des Hologramms kann mit der binären Maske eine gleiche Performance erreicht werden, wie mit einer idealen (PSM-Phasen-Shift-Maske). Im Falle komplizierterer oder kleinerer Strukturen können Hologramme eingesetzt werden, welche komplexere Phasenverteilung erzeugen. Erste Erfahrungen zeigen, daß wenige Standard-Hologramme genügen, um viele in der Halbleiterindustrie benötigte Design-Formen herzustellen, und in die strahlungsempfindliche Schicht hineinzubelichten. Bei der Herstellung der Hologramme können Standardverfahren aus dem Design synthetischer Hologramme Anwendung finden und der Einfluß der Topographie der Hologramme auf die Lichtbeugung kann durch die eingangs beschriebene rigorose Feldsimulation beschrieben werden, um damit Imbalancing-Effekte zu vermeiden.

Die wenigen beschriebenen Standard-Hologramme, um die gängigen in der Halbleiterindustrie eingesetzten Design-Formen herzustellen, können in großer Stückzahl und ökonomisch günstig hergestellt werden.

Eine Justage des Hologramms bezüglich der Maske und ihren räumlich/geometrisch verteilten transmittierenden und nicht-transmittierenden Zonen kann bevorzugt durch geeignete Justage-Strukturen (Alignment-Strukturen) auf gleichermaßen Hologramm sowie Maske erfolgen. Entsprechende Verstelleinrichtungen sind beispielsweise bekannt aus dem Maskenprozeß des Wafersteppers, mit Justieroptiken, LaserInterferometer und/oder x-y-Verfahreinrichtungen für die Maske und/oder das Substrat, auf dem die Abbildung der Transmissions-Topologie der Maske als Intensitäts-Topologie erscheint.

Ausführungsbeispiele der Erfindung erläutern und ergänzen ihr Verständnis.
- **Figur 1**: ist eine Standard-Maske mit transmittierenden und nicht-transmittierenden Bereichen sowie ihr Transmissions-Verhalten in einer Schnittdarstellung, aber ersichtlich bezogen auf eine Ebene x, y, die als solches nicht dargestellt ist.
- **Figur 2**: ist eine Realisierung einer binären Maske mit einem in der Phase verschobenen Lichtanteil L2, sein Transmissionsverhalten durch die Maske und die Abbildung in einer lichtempfindlichen Schicht 3 auf einem Substrat 2.
- **Figur 3**: veranschaulicht in schematischer Darstellung den Strahlweg und die optische Achse eines Abbildungssystems zur Belichtung der lichtempfindlichen Schicht 3 auf einem Substrat 2, ausgehend von einer Lichtquelle 1.
- **Figur 4**: zeigt die Anbringung eines Hologramms 2, auf die das Licht L gemäß Figur 3 einfällt. Hier ist auch die Maske 10 dargestellt, mit einer zugeordneten Masken-Schutzschicht 30.
- **Figur 5a Figur 5b Figur 5c**: zeigen das Transmissionsverhalten und das Phasen-Verhalten in 3 Diagrammen, bezogen auf das vom Hologramm erzeugte Bild, das Transmissionsverhalten der binären Maske und die Intensität und Phase der Kombination beider obigen Bilder nach Durchstrahlung durch Maske und Hologramm.

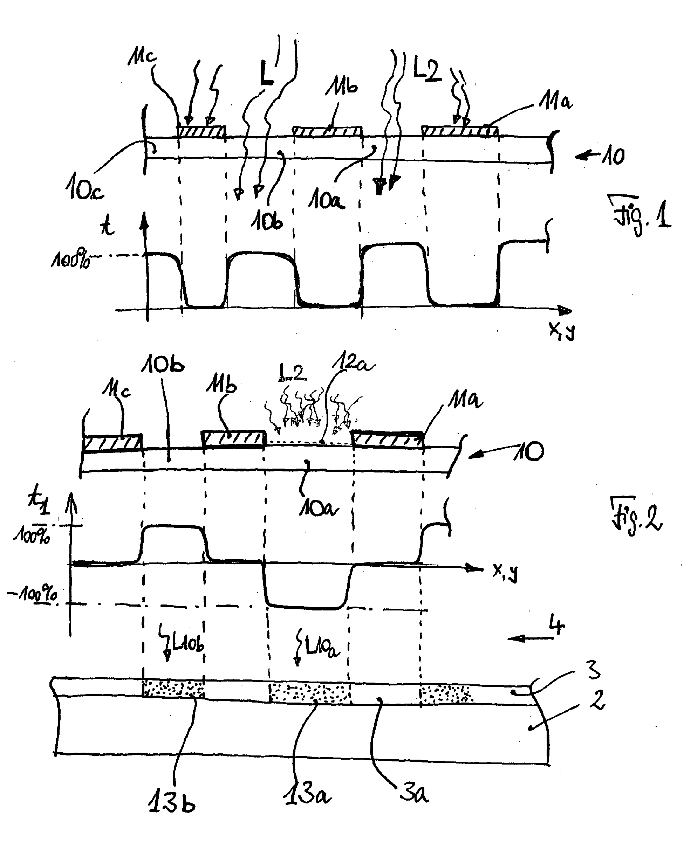

**Figur 1** veranschaulicht im Ausschnitt eine Maske 10, deren Anbringungsort und Orientierung schematisch in **Figur 3** erläutert ist. Ausgehend von Figur 3 soll aufgezeigt werden, wie der strukturelle Aufbau der Belichtung einer lichtempfindlichen Schicht 3, wie ein Negativ- oder Positivphotoresist auf einem Substrat 2, hier dargestellt als ein Halbleiter, vor sich geht.

Eine Lichtquelle 1, mit einer Strahlungsabgabe L beleuchtet ein Hologramm 2. Von diesem Hologramm wird ein Interferenzmuster erzeugt, das hinsichtlich Intensität und Phase an bestimmten Stellen 12a verschoben ist gegenüber bestimmten anderen Stellen, was später näher erläutert wird. Das so gebildete Licht L2 trifft auf eine Maske 10, die in dem Bereich 10a transparent, also für das Licht durchlässig ist. Im jeweils benachbarten Bereich ist die Maske 10 nicht transparent, z.B. opak durch Bilden von Schichtsegmenten aus Chrom. Das durch die Öffnung 10a hindurchtretende Licht L10 ist in der Phase moduliert und bildet insgesamt über die Maskenfläche in x-, y-Richtung der Maske 10 Lichtfiguren, die über eine Abbildungoptik 4, mit Eingangs-Lichtstrahlen L10 und Ausgangs-Lichtstrahlen L4 die lichtempfindliche Schicht 3 belichten.

Das gezeigte Schema sorgt für Lichtfiguren auf dem Resist 3, also eine Intensitätsmodulation, die eine vorgegebene Struktur abbilden und vorgegebene chemische Reaktionen zur Bildung der Struktur in dem Resist auslösen. Ein nachfolgender Ätzvorgang, im Sinne einer Entwicklung des Resistes, sorgt für eine in die Tiefe gehende Ausbildung des Resists 3 und erlaubt eine weitere Bearbeitung in einem weiteren Prozeßschritt, wie ein Ätzvorgang, einen weiteren Belichtungsvorgang, einen Dotierungsvorgang oder ähnliche Vorgänge, die für die Halbleiterfertigung von Bedeutung sind. Die Größe der Strukturen soll hier als unter 1 µm angegeben werden, bis derzeit hin zu unter 200nm, ist aber nicht auf diese Größenordnung beschränkt, sondern kann auch für größere Auflösungen Anwendung finden.

Die Figurendaten zur Ausbildung des Designs der Maske 10 in ihrem Transmissionsverhalten werden aus einem Rechner ausgelesen und mit Hologramm-Informationen in der Hologrammplatte 2 synchronisiert.

In einem Ausschnitt aus Figur 1 kann ersehen werden, wie der transmittierende Bereich 10a der Maske 10 zwischen zwei opaken Abschnitten 11a und 11b zu liegen kommt und von dem Licht L2 durchstrahlt wird, das in Figur 3 auch mit L2 benannt ist. Der benachbarte Bereich 10b, der ebenfalls Licht L transmittiert, ist ebenfalls von zwei opaken, nicht transmittierenden Segmenten 11b, 11c eingegrenzt. Es schließt sich ein weiterer transmittierender Bereich 10c an, der entsprechend demjenigen von Figur 10a ausgebildet ist, wie weiter unten beschrieben wird.

Das Transmissionsverhalten ist in der unteren Funktion in Figur 1 abhängig von x, y dargestellt. Es ist eine binäre Maske, bei der praktisch nur Durchlaß und praktisch nur Sperrverhalten erzeugt wird, wobei der Transmissionsgrad t = t(x,y) in den durchlässigen Bereichen 10a,10b,10c mit im wesentlichen 100% angegeben werden kann, während er in den opaken Bereichen 11c,11b,11a mit im'wesentlichen 0% oder einem geringen Prozentsatz angegeben werden kann. Randeffekte sind für die schematische Darstellung vernachlässigt.

In **Figur 2** ist die Maske 10 im Ausschnitt von Figur 1 nochmals dargestellt, hier allerdings mit einer zusätzlich unter der Maske 10 gelegenen Substratschicht 2 mit lichtempfindlicher Schicht 3, wobei die Abbildungsoptik 4 der Übersichtlichkeit halber fortgelassen ist, aber mit hinzuzurechnen ist. Ersichtlich an Figur 2 ist die Invertierung der Phase im transmittierenden Bereich 10a, bei Beibehaltung der Phase im wesentlichen in dem transmittierenden Bereich 10b der Maske 10. Für den Bereich 10c gilt Entsprechendes, wie für den Bereich 10a dargestellt. Ein hier einfallendes Licht L2 ist von dem Hologramm 2 in seiner Phase bereits so beeinflußt, daß ohne eine gesonderte Zwischenlage, ohne unterschiedliche Höhen in den transmittierenden Bereichen 10a,10b und ohne sonstige Maßnahme eine Phasenschiebung der benachbarten lichtdurchlässigen Bereiche 10a,10b erreicht werden kann. Letzteres geht aus dem Transmissions-Diagramm anhand der Funktion t1 hervor, die zwischen 100% und -100% schwankt und in den opaken Bereichen 11a,11b,11c keine Durchlässigkeit besitzt. Dementsprechend wird in den Bereichen 13a,13b der Resist 3 belichtet, während er in den Abschnitten 3a,3b, entsprechend den opaken Abschnitten 11a,11b unbelichtet bleibt. Der belichtende Anteil L10a und L10b ist in Gegenphase ausgerichtet, so daß sich im Zwischenbereich 11 b, der dunkel zu sein hat, wenig Licht an den Beugungskanten der opaken Abdeckung 11b einfindet, um die Grenze an den Kanten möglichst scharf zu erhalten, bei einem relativ hohen Gradienten. Damit lassen sich sehr kleine Strukturen abbilden, die durch die Phasenschiebung des Lichts 12a im Bereich 10a gegenüber dem Bereich 10b verbessert wird.

Trotz Vorsehen einer binären Maske 10 kann mit dem gesonderten Hologramm zwischen der Lichtquelle 1 und der Maske 10 eine Phasenschiebe-Maske erhalten werden, die einfacher herzustellen ist, als übliche Phasenschiebe-Masken, bei denen der Zwischenraum 10a mit einem Werkstoff zur Phasenschiebung belegt ist.

Die Phasenschiebung erfolgt zwischen der Lichtquelle und der Maske, also räumlich von dieser getrennt. Sie ist auch zeitlich von ihr getrennt. Die Maske 10 wird zunächst hergestellt und erst später, während des Verfahrens, wird die Phasenschiebung bei dem Belichtungsvorgang im Bereich 10a induziert, durch Einsetzen des ein Interferenzmuster bildenden Hologramms 2. Das Herstellverfahren für die Standard-Maske 10, beispielsweise eine COG-Maske, kann ein Standardverfahren sein. Das zweite Teilverfahren zur Herstellung der insgesamt wie eine Phasenschiebe-Maske wirkenden Gesamtanordnung entsteht erst im Zeitpunkt der Belichtung. Es kann also unabhängig voneinander die Maske optimiert werden und die Position, Orientierung und Ausrichtung des Hologramms 2 gegenüber der strukturierten Maske festgelegt werden. Beide Elemente des Gesamtverfahrens können eigenständig optimiert werden und beeinflussen sich nicht gegenseitig. So kann das Hologramm selbst aufgrund von vorgespeicherten Standard-Hologrammen als Figuren oder Design-Formen gebildet werden, unabhängig von dem Herstellungsprozeß der Maske 10.

Die Phasenlage wird oberhalb der Maske vorgenommen, wobei oberhalb so zu verstehen ist, daß es oberhalb der Gesamtmaske 10 aus transmittierenden Bereichen 10a und nicht transmittierenden Bereichen 11a,11b,11c ist. Die Maske ist zwar in den Figuren so dargestellt, daß die opaken Abschnitte nach oben zur Lichtquelle 1 zeigen, meist wird die Maske aber invertiert verwendet, wobei die opaken Bereiche von der Lichtquelle abgewandt sind.

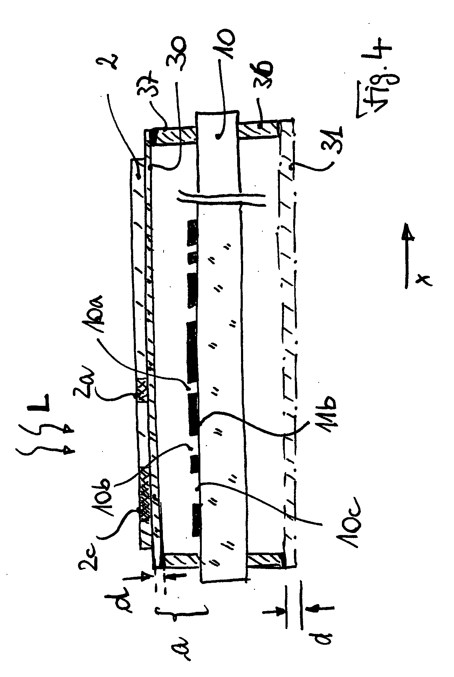

Bevorzugt wird das Hologramm so angeordnet, wie in der folgenden **Figur 4** erläutert wird. In **Figur 4** ist die Maske 10 als eine binäre Maske dargestellt, mit den schematisch gezeigten nicht transmittierenden Bereichen, z.B. 11b, und den transmittierenden Bereichen 10a,10b. In einem Abstand a oberhalb dieser Maske, gehalten von Stützen 37, ist eine Masken-Schutzschicht 30 vorgesehen. Sie wird als Pellicle bezeichnet, und auf ihr liegt das Hologramm 2, das zumindest für die Bereiche 10a und 10c so gestaltet ist, daß die Phase des einfallenden Lichtes L gegenüber demjenigen Lichtanteil um im wesentlichen 180° gedreht wird, der in den Bereich 10b als zwischenliegender transmittierender Bereich einfällt.

Am Ausgang der Maske 10 ergeben sich die Verhältnisse des Transmissionsverhaltens, die in Figur 2 in dem mittleren schematischen Diagramm mit der Funktion t1 (x,y) gezeigt sind.

Die x-Richtung ist nach rechts orientiert, während die y-Richtung in die Papierebene hinein orientiert ist, hier nicht gezeigt wird, sich aber aus dem Zusammenhang für den Fachmann ergibt.

In Figur 4 ist die Maskenschutzschicht 30 mit einer Dicke d eingezeichnet, die im Abstand a von einigen Millimetern von der Oberfläche der Maske 10 angeordnet ist. Die Dicke d ist klein gegenüber der Stärke der Maske 10. Oft wird als Schutzschicht eine Nitro-Zellulosemembran verwendet, die lichtdurchlässig ist, aber Verbesserungen bei den Defekten bietet und störende Partikel, die auf ihr gelagert werden, außerhalb des Tiefenschärfebereichs in ihrer Wirkung herabsetzt. Die Beabstandung "a" entspricht deshalb zumindest dem Wert der Fokustiefe oder Tiefenschärfe des Abbildungssystems, was dann auch für den Abstand des Hologramms 2 gilt, das auf der Schutzschicht 30 aufliegt. Eine parallele Schutzschicht 31 ist aus Symmetriegründen auf der anderen Seite mit einem weiteren Abstandshalter 36 angeordnet, für den gleiches gilt, nur ist hier kein Hologramm aufgelegt oder angelegt.

Das Hologramm 2 kann gegenüber der in Figur 4 dargestellten Lage auch weiter aufwärts in Richtung der optischen Achse 100a nach Figur 3 verschoben werden, bis hin zur Lichtquelle 1. Es ist seitlich justierbar durch entsprechende Geber oder Aktoren, die eine Relativverschiebung der phasendrehenden Bereiche 2a,2c relativ zu den transmittierenden Abschnitten 10a,10c erlauben. Gleiches auch in Richtung y, die gemäß obiger Darstellung hier nicht explizit gezeigt ist.

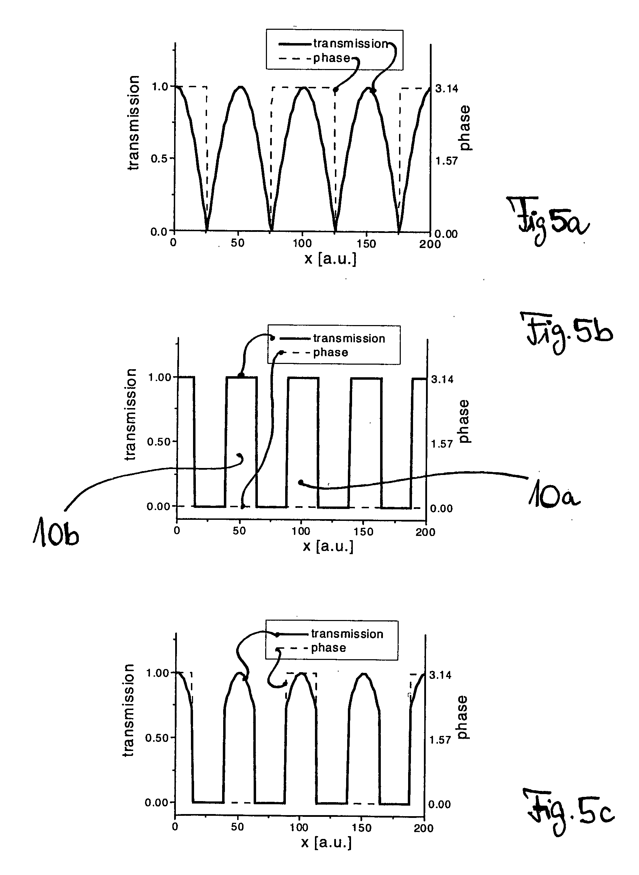

Als Interferenzmuster des Hologramms 2 kann ein Phasengitter Verwendung finden, welches die gewünschte Phasenschiebung in den Bereichen 10a,10c erreicht. Das Phasengitter hat im Vergleich zum binären Gitter die doppelte Periode, wobei sich nach Transmission durch die binäre Maske 10 die in **Figur 5c** dargestellte Gesamttransmission des in Figur 3 gezeigten Systems ergibt.

**Figuren 5** zeigen mit der Figur 5c das Ergebnis. Die beiden Ausgangs-Teilverfahren in dem Sinne des Arbeitsverfahrens oder Herstellungsverfahrens bezogen auf das Substrat, zeigen die Entstehung der bereichsweisen Phasenschiebung trotz Verwendung einer binären Maske. Die binäre Maske ist in ihrem Transmissionsverhalten und in ihrem Phasenverhalten in der **Figur 5b** dargestellt. Jeweils an den Transmissionsstellen, die mit"1" (100%) bezeichnet sind, herrscht derjenige Zustand, der mit den Bereichen 10a,10b,10c in Figur 2 den Lichtanteil L10a und L10b durchläßt. Die Breite des 100%-Anteils von Figur 5b entspricht der Breite der lichtdurchlässigen Bereiche 10b,10a und 10c. Die Phase ist unverändert, sie ist mit 0° angegeben und auf der Abszisse ist die x-Richtung dargestellt.

Die mit dem Hologramm 2 nach Figur 3 oder auf der Schutzschicht nach Figur 4 erzeugte Phasenschiebung zeigt **Figur 5a.** Hier tritt durch das Hologramm auch eine sin²-ähnliche Veränderung des durchstrahlenden Lichtes L2 auf, das aber abschnittsweise, also bei jeder zweiten Amplitude der Intensität eine Phase von π (pi) im Bogenmaß entsprechend 3,14 besitzt. Jede Zwischenamplitude besitzt die Phase 0, bei aber vergleichbaren Amplitudenverlauf in Phase und Gegenphase. Die Phasenänderung ist so justiert, daß sie auf die x-Koordinate 0, 100 und 200 zentriert ist, an welchen Stellen in Figur 2 die transmittierenden Bereiche 10a,10c liegen, und auch ein weiterer, hier nicht eingezeichneter Bereich 10e. In dem Bereich 10a und 10c erhält man eine Amplitude entsprechend Figur 5a und eine Phase entsprechend Figur 5a, mit einer scharfen Kante gemäß Figur 5b. Diese scharfe Kante hat einen hohen Gradienten im Intensitätsverlauf und stellt damit sicher, daß auch kleine Strukturen aufgelöst werden können.

Bezogen auf die Figur 3 entspricht die Figur 5a in ihrem Verhalten dem Licht L2. Die Figur 5c entspricht dem Licht L10 und L4. Das Transmissionsverhalten der Figur 5b entspricht - ohne Hologramm 2 - dem Lichtanteil L10 von Figur 3, wobei mehrere transmittierende Bereiche in Lateralrichtung vorstellbar sind.

## Patentansprüche

1. **Verfahren** zum Herstellen oder Erzeugen von optisch abbildbaren Strukturen, insbesondere in einer Größenordnung unter 1µm, auf einem Substrat (2), wie Halbleiterchip oder Halbleiterwafer,
wobei eine Maske (10) verwendet wird, die entsprechend der Gestalt von zu bildenden kleinen Strukturen (13a,13b) lichtdurchlässig (10a,10b,10c) ist, zum Belichten der kleinen Strukturen und zum Ausbilden einer Intensitätstopologie (3a,13a,13b) auf einer lichtempfindlichen Schicht (3), die auf dem Substrat (2) - insbesondere dem Halbleiter - aufgebracht ist; ***dadurch gekennzeichnet, daß***
(a) ein erstes Teilverfahren zur Definition einer Form und Verteilung der lichtdurchlässigen Bereiche (10a,10b,10c) in oder auf der Maske (10) räumlich (a) und zeitlich getrennt wird von
(b) einem zweiten Teilverfahren zur Veränderung der Phasenlage (12a) der durch bestimmte Bereiche (10a,10c) der lichtdurchlässigen Bereiche transmittierten Lichtanteile (L10a) während der Belichtung der lichtempfindlichen Schicht (3).

2. Verfahren nach Anspruch 1, bei dem die Maske (10) in ihrem Transmissions-Verhalten über ein optisches Abbildungssystem (4) in die lichtempfindliche Schicht (3) auf dem Halbleiter abgebildet wird.

3. Verfahren nach Anspruch 1, wobei die Maske (10) mit einem Interferenzmuster beleuchtet wird (12a), welches mit einem Hologramm (2) erzeugt wird.

4. Verfahren nach Anspruch 3, wobei das Hologramm (2) zwischen einer Lichtquelle (1) und der als binäre Maske ausgebildeten Maske (10) im Strahlweg (L2,L10,L4,100a) angeordnet ist.

5. Verfahren nach Anspruch 1, wobei die Maske (10) eine Phasenshift-Maske (Phasenmaske) ist, bei welcher die bestimmten transparenten Bereiche (10a), die übrigen transparenten Bereiche (10b) und die nicht transparenten Bereiche (11b,11c,11a) entsprechend der Struktur der Form oder kleinen Strukturen (3a,13a,13b) auf dem Halbleiter (2) vorgesehen sind und wobei die bestimmten transparenten Bereiche und die übrigen transparenten Bereiche abwechselnd so angeordnet sind, daß benachbarte transparente Bereiche um zumindest einen nicht transparenten Bereich beabstandet sind und eine unterschiedliche Phasenlage, Laufzeit oder Phasenänderung in den hindurchtretenden Lichtanteil (L10a, L10b) einbringen.

6. Verfahren nach Anspruch 5, wobei die Phasenlage im wesentlichen eine Gegenphase im Sinne einer Phasenverschiebung um 180° ist, bezogen auf jeweils zwei benachbart beabstandete transparente Bereiche (10a,10b).

7. Verfahren nach Anspruch 1, wobei das Herstellverfahren eine Projektionslithographie ist, mit einem Projektionssystem (4) zur Abbildung des von der Maske (10) in seiner Intensität und Phase modulierten Lichtes (L10,L10a,L10b).

8. Verfahren nach Anspruch 1, wobei die Maske (10) aus Glas besteht, insbesondere Quarzglas, und die nicht transparenten Bereiche (11a,11b,11c) aus einer Schicht aus insbesondere Chrom bestehen bzw. im wesentlichen diese Substanz aufweisen.

9. Verfahren nach Anspruch 1, wobei das Licht (1,L,L2,L10,L4) im sichtbaren oder nicht sichtbaren Wellenlängenbereich liegt.

10. Verfahren nach Anspruch 1, wobei das erste Teilverfahren zur Definition der Form und Verteilung der lichtdurchlässigen Bereiche ein Standardverfahren zur Erstellung einer binären Maske (10), noch ohne bestimmte, phasenschiebende lichtdurchlässige Bereiche ist.

11. Verfahren nach Anspruch 1, wobei die Veränderung der Phasenlage in den bestimmten, lichtdurchlässigen Bereichen (10a) durch ein Hologramm (2) erfolgt, insbesondere ein Phasengitter, um ein Interferenzmuster auf die Maske (10) zu projizieren.

12. Verfahren nach Anspruch 11, wobei das Hologramm (2) sich auf der optischen Achse (100a) zwischen einer Lichtquelle (1) und der Maske (10) befindet bzw. dort angeordnet ist, insbesondere nahe einer Masken-Schutzschicht (30), die in einem Abstand (a) von der Maske gehalten ist (37) und lichtdurchlässig ist.

13. Verfahren nach Anspruch 12, wobei die Maske eine binäre Maske (10) ist, die nur gleichartige lichtdurchlässige Bereiche besitzt (10a,10b,10c), welche dem transmittierten Lichtanteil keine oder zumindest im wesentlichen dieselbe Phasenverschiebung erteilen bzw. keine wesentliche Phasendifferenz zwischen transmittierten Lichtanteilen erzeugt.

14. Verfahren nach Anspruch 11, wobei eine Phasenverschiebung des durchtretenden Lichtanteils in den bestimmten Bereichen (10a) durch eine Beleuchtung mit einem Interferenzmuster (12a) erfolgt.

15. Verfahren nach Anspruch 1, wobei die Beleuchtung der Maske (10) mit einem Interferenzmuster erfolgt, welches eine Phasenschiebung in den lichtdurchlässigen, vom Interferenzmuster (12a) beleuchteten Bereichen induziert.

16. Verfahren nach Anspruch 1, wobei die Intensitätstopologie zu einer flächigen Verteilung als Strukturtopologie führt, im Sinne von belichteten und nicht belichteten Zonen (3a,13a) in der lichtempfindlichen Schicht (3).

17. Verfahren nach Anspruch 1, wobei das zweite Teilverfahren zur Erzeugung der Phasenschiebung während der Beleuchtung der lichtempfindlichen Schicht (2) erfolgt.

18. Verfahren nach Anspruch 1, wobei das Substrat (2) zumindest einen flächigen (x,y) Halbleiter aufweist und zu einem Speicherbaustein oder einem Logikbaustein nach einer Entwicklung der belichteten lichtempfindlichen Schicht (3) und weiterer solcher Verfahrensschritte prozessiert wird.

19. Verfahren nach Anspruch 1 oder 18, wobei nach der Belichtung der kleinen Strukturen eine Entwicklung erfolgt, zum Ausbilden einer der Intensitäts-Topologie entsprechenden, in die Tiefe der lichtempfindlichen Schicht (3) reichenden Strukturtopologie oberhalb des Substrats (2), insbesondere Halbleiters.

20. Verfahren zum Herstellen oder Erzeugen von optisch abgebildeten (4) Strukturen auf Substraten, wie Halbleiterchips oder Wafern, wobei zur Belichtung einer lichtempfindlichen Schicht (3), die von dem Substrat (2) getragen wird,
(a) eine Maske (10) oberhalb des Substrats plaziert wird, die entsprechend einer Gestalt von zu bildenden kleinen Strukturen (13a,13b) lichtdurchlässig (10a,10b,10c) ist, zum Belichten der kleinen Strukturen aus einer Strahlenquelle (1) und zum Ausbilden einer Intensitäts-Topologie (3a,13a,13b) auf der lichtempfindlichen Schicht (3);
(b) eine Definition der Form und Verteilung der lichtdurchlässigen Bereiche (10a,10b,10c) in oder auf der Maske (10) vor der Belichtung der kleinen Strukturen erfolgt;
(c) durch bestimmte Bereiche (10a) der lichtdurchlässigen Bereiche (10a,10b,10c) transmittierte Lichtanteile (L10a) während der Belichtung der kleinen Strukturen im Stahlenweg (L2,L10,L4,100a) oberhalb der Maske (10,11) eine Veränderung der Phasenlage (2,12a) erhalten.

21. Einrichtung zum Belichten von optisch abzubildenden (4) Strukturen auf ein Substrat, wobei eine lichtempfindliche Schicht (3) von dem Substrat (2) getragen wird, und
(a) eine Maske (10) oberhalb des Substrats plaziert ist, die entsprechend einer Gestalt von zu bildenden kleinen Strukturen (13a,13b) lichtdurchlässig (10a,10b,10c) ist, unter Definition von Form und Verteilung der lichtdurchlässigen Bereiche (10a,10b,10c) der Maske (10);
(b) eine Strahlenquelle (1) oberhalb der Maske vorgesehen ist, zum Belichten der kleinen Strukturen und zum Ausbilden einer Intensitäts-Topologie (3a,13a,13b) hinter der Maske (10) und auf der lichtempfindlichen Schicht (3);
(c) oberhalb der Maske (10,11) eine Phasen-Einrichtung (2) zur Veränderung der Phasenlage (12a) in bestimmten lichtdurchlässigen Bereichen (10a) der Maske, um bestimmte transmittierte Lichtanteile (L10a) während der Belichtung der kleinen Strukturen gegenüber den übrigen transmittierten Lichtanteilen (L10b) in der Phase deutlich zu verändern.
